# EUROPEAN PATENT APPLICATION

(11) **EP 1 827 066 A2**
(43) Date of publication of application: **29.08.2007**
(21) Application number: 07250751.0
(22) Date of filing: 22.02.2007
(51) Int. Cl.: H05K 3/10

(54) **Electron attachment assisted formation of electrical conductors**

(30) Priority: 23.02.2006 US 775906 P; 06.07.2006 US 481444
(71) Applicant: Air Products and Chemicals, Inc., Allentown, PA 18195-1501 (US)
(72) Inventor: Dong, Chun Christine, Macungie, PA 18062 (US); Karwacki, Eugene Joseph, Jr., Orefield, PA 18069 (US); Patrick, Richard E., Tamaqua, PA 18252 (US); Roberts, David Allen, Fogelsville, PA 18051 (US); Pinschmidt, Robert Krantz, Jr., Allentown, PA 18104 (US); Norman, John Anthony Thomas, Encinitas, CA 92024 (US); Ivankovits, John Christopher, Allentown, PA 18103 (US)
(74) Representative: Muir, Benjamin M. J.

(57) **Abstract**

Electrical conductors and films are formed by exposing conductor formulations comprised of metal particles or metal precursors or mixtures thereof, typically in the form of an ink or paste, to an electrically activated reducing gas at sufficient heat and for a sufficient time to effect sintering thereof.

## Description

### BACKGROUND OF THE INVENTION

The electronics, display and energy industries rely on the formation of coatings and patterns of electrical conductors comprised of conductive metals on organic and inorganic substrates to form circuits. The electrical conductors are used for producing conductive lines for flat panel displays; antennas for cellular telephones and radio frequency (RF) tags; for forming the electrodes, as well as the bus lines and barrier ribs, for plasma display panels; for making inductor-based devices including transformers, power converters and phase shifters; for manufacturing low cost or disposable electronic devices; for forming under-bump metallization; for serving as solder replacements; and for providing connections between components and chips in smart cards and RF tags.

Recent developments in forming electrical conductors have focused upon additive methods for application of the conductive medium at the desired site. The subtractive method, in contrast to the additive method, has the conductive material applied over a wide area and then the conductive material is selectively removed from non desired areas. Additive approaches to building circuits involve far fewer process steps, they use less material and minimize the waste normally associated with subtractive methods. They may also eliminate the need for high-cost vacuum processes.

Thick film technology is one method of additively building electrical conductors. Metal particles and fine glass particles are stenciled or screen printed onto substrates to create additive circuits. Early thick film technology required extremely high temperatures (>650°C) to sinter the metals. Only those substrates that could sustain such temperatures, such as silicon, ceramics and glass, could be used. Thus, substrate selection was limited. Also, the products developed by thick film were relatively expensive.

Polymer thick film (PTF) technology is another example for additively building electrical conductors with the advantage that lower temperatures can be used as opposed to thick film technology. Metal particles are dispersed in a polymer binder and stenciled or screen printed onto polymer and paper substrates. The major limitation of this PTF technology is that the materials typically have only about 10-20% of the conductivity of the best high temperature electrical conductors produced by thick film technology, which conductivity is only 30 to 50% that of bulk metal conductors.

Recently, inks and pastes comprised of metal precursors have been developed which can be applied to a variety of substrates and converted to a conductor on heating. However, conversion of the metal precursors to conductive metals, especially copper, also has required temperatures too high for use with some low-cost flexible substrates, such as thermoplastic polymers and paper. Therefore, a low temperature process is required if one is to form an electrical conductor on these substrates.

The following patents and articles are representative of the art with respect to producing electrical conductors comprised of conductive metals on substrates and particularly the formation of electrical conductors from metal precursors.

US 6,036,889, US 6,143,356, US 6,153,348, US 6,274,412 B1, US 6,379,745 B1 disclose a family of precursor compounds that are commercially available under the trademark, PARMOD™. These compositions can be printed on substrates such as those used for printed wiring boards and flexible circuits and they offer the advantage that metallic conductors with fine features can be produced by a simple print-and-heat process instead of by the usual multi-step photolithographic etching process.

Printable inks or pastes are comprised of a Reactive Organic Medium (ROM) and metal flakes and/or metal powders, which are blended together with an organic vehicle. When the ink or paste is heated, metal is generated by thermal decomposition and the generated fresh metal "chemically welds" the flakes and/or powder constituents of the mixture together into a conductive network structure.

WO 03/032084 A2 (US 2003/0180451) discloses low viscosity precursors for the deposition of conductive electronic features which allow for application by the direct-write method, e.g., ink jet deposition. In an effort to lower the sintering temperature of the metal precursor(s) employed in the ink or paste the particle size of metal powders was reduced with the particulates falling into the nanometer and micron size. Representative nanoparticles include CuₓO (sic), Ag and pyrogenous silica. Conductive metal oxides of indium, antimony, platinum and nickel are also suggested as candidates for forming the conductor.

US 6,776,330 discloses a process for dry fluxing metal surfaces that are to be soldered. The approach for dry fluxing employed is referred to as electron attachment, which requires supplying a reducing gas to a target positioned between electrodes. A negatively charged reducing gas, e.g., negatively charged hydrogen, is employed in the dry fluxing process.

US 2004/0211675 discloses a method for removing metal oxides from the surface of a substrate comprising a plurality of solder bumps wherein at least a portion of the surface comprising the plurality of solder bumps is exposed to a gas mixture comprising a negatively charged reducing gas and a carrier.

US 2004/0226914 discloses a method for removing metal oxides from a surface of at least one component comprising: passing a reducing gas through an ion generator and form a negatively charged reducing gas; and contacting a target assembly with the negatively charged reducing gas to reduce the oxides on the at least one component.

US 2004/0231597 discloses the dry fluxing of a solder surface using electron attachment. In the process oxides of various components on solder surfaces are removed by negatively charged hydrogen ions.

### BRIEF SUMMARY OF THE INVENTION

This invention is directed to an improvement in the formation of an electrical conductor comprised of a conductive metal carried on a substrate generally of the type employed in the electronics industry. In the basic process a conductor formulation generally comprised of at least one ingredient selected from metal particles and metal precursors and mixtures thereof, typically in the form of an ink or paste, is applied to the substrate and converted into an electrical conductor by application of sufficient heat and for a sufficient time to effect sintering thereof. The improvement in the process resides in using the process of electron attachment for facilitating the sintering and the conversion of the ingredient to a metal.

Significant advantages can be achieved by the process and these include:
an ability to produce electrical conductors on a variety of substrates, including flexible temperature sensitive substrates, at low temperatures;
an ability to generate electrical conductors under ambient pressure;
an ability to generate electrical conductors using a non toxic and non flammable gas mixture;
an ability to employ metal precursors such as copper and silver precursors to facilitate the formation of electrical conductors on a variety of substrates at temperatures of 200 °C and below;
an ability to effect sintering of metal particles at temperatures of 200 °C and below; and,
an ability to achieve conductive lines and features having low electrical resistivity on porous paper and polymeric substrates or on a semiconductive surface.

Thus, according to a first aspect the present invention provides a method of forming an electrical conductor on a substrate which comprises the steps: applying a conductor formulation comprised of at least one ingredient selected from metal particles, metal precursors and mixtures thereof onto a substrate; exposing the conductor formulation to an electrically activated reducing gas; and, converting the ingredient to metal and forming the electrical conductor.

According to a second aspect, the present invention provides a process for forming a film from a conductor formulation comprised of at least one ingredient selected from metal particles, metal precursors and mixtures thereof and converting the ingredient to sintered metal, which comprises: exposing the conductor formulation to a negatively charged ionic reducing gas to convert said ingredient to a metal and to sinter the thus formed metal.

According to a third aspect, the present invention provides a process for forming an electrical conductor, which comprises the steps of:
(a) applying a formulation comprised of at least one ingredient selected from metal particles, metal precursor and mixtures thereof onto a substrate, said metal in said metal particles or metal precursor selected from of copper, silver and mixtures thereof;
(b) contacting the formulation with an electrically activated reducing gas comprised of an inert gas and hydrogen wherein said hydrogen is present in said reducing gas in an amount from 1 to 4 % by volume; and,
(c) converting said ingredient to metal and sintering the thus formed metal.

### DETAILED DESCRIPTION OF THE INVENTION

Recently, there has been substantial interest in processes which allow for the low-temperature formation of patterns of highly conductive metals carried on a substrate, particularly low cost substrates such as paper and polymeric films. Processing temperatures of 200 °C and preferably ≤150 °C are of special significance especially for producing high conductivity copper patterns on temperature sensitive substrates, e.g., thermoplastics and paper.

Electrical conductors produced by the additive method are prepared from conductor formulations which generally comprise a metal particle combined with a metal precursor which can be converted to conductive metal. In most cases conductor formulations include a mixture of a metal precursor and/or metal particle and a liquid vehicle, e.g., a solvent. There are several reactions which need to be completed during the process of generating high conductivity metal patterns. One reaction for generating electrical conductors is breaking down the metal precursor into metal and organic byproducts. A second reaction requires the removal of any oxides which may be present on the surface of contained metal particles. A third reaction is one that achieves removal of any organic material which may be present either originating from the organic component of the conductor formulation, from the stabilizers that prevent premature metal powder agglomeration, from additives acting as binders, surface energy, viscosity or adhesion promoters, or the liquid vehicle. In the fourth reaction the thus formed finely divided metals are fused or sintered to form a conductive metallic conductor.

The improvement in the process for forming electrical conductors by the application of a conductor formulation comprised of at least one metal particle or at least one metal precursor or mixture thereof onto a substrate and effecting conversion of the metal particle or metal precursor to metal and effecting the formation of the electrical conductor thereof resides in the employment of electron attachment (EA) wherein the metal particle or metal precursor is exposed to an electrically activated reducing gas for a time and at a temperature sufficient to convert the metal particle or metal precursor to a sintered conductive metal.

The term "electrical conductor" it is meant to refer to the product produced by the claimed process, which may be employed in an application other than an electrical application, e.g., as a thermal conductor or reflective coating application.

Conductor formulations for producing electrically conductive patterns on substrates incorporate a metal particle or metal precursor or combination thereof that can be converted to a sintered metal. Conductor formulations also can be comprised of nonmetal additives, e.g., indium/tin oxide (ITO) which in itself is conductive and bonded with the conductive metal.

There are basically two types of ingredients or metal components employed in conductor formulations. One type is based upon nano and/or micron sized metal powders or metal flakes and the other is based upon metal compounds having the general formula M^{(+a)}_{y}X^{(-b)}_{w}L_{z} where M is a metal suited for use in producing electrical conductors and X is a negatively charged ligand, L is a neutral ligand and where ay = bw and a is from 1-5, b is from 1-3 and z is from 0 to 5. These metal compounds are sometimes referred to as metallo-organic decomposition compounds (MOD). Many of the conductor formulations in the form of inks or pastes employ a combination of nano and micron size metal powders and one or more metallo-organic decomposition compounds.

Suitable metals useful as the metal particles in the conductor formulations include copper, silver, gold, zinc, cadmium, palladium, iridium, ruthenium, osmium, rhodium, platinum, iron, cobalt, nickel, manganese, indium, tin, antimony, lead, bismuth, vanadium, chromium, titanium, tantalum, aluminum, magnesium, calcium, strontium, barium, cadmium, gallium, bismuth, or a combination among them. More preferably the metals are selected from Cu, Ag, Ni, and Au, with copper being most preferred, due to its relatively low cost, high conductivity, and high electrical migration resistance.

As mentioned previously, one type of conductor formulation is based upon "metal particles", which include nanopowders having an average size of not greater than 100 nanometers, such as from 5 to 80 nanometers. Particularly preferred are nanopowders having an average size of not greater than 75 nanometers, such as in the range of from 25 to 75 nanometers. Preferred nanopowder compositions include copper, silver, palladium, gold, platinum and nickel.

The term "metal particles" is also intended to include the term "metal flake" having a major dimension between 1 to 10 microns, preferably between 1 to 5 microns, and a thickness of less than 1 micron. Flakes can perform several functions. They form a skeleton structure in the printed image which holds the other ingredients together and prevents loss of resolution when the mixture is heated to cure the ink. The flakes naturally assume a lamellar interlocking structure akin to how the rocks of a stone wall are laid together which provide electrical conductivity in the direction parallel to the surface of the substrate and provide a framework to lessen the amount of metal transport necessary to achieve the well-consolidated pure metal conductors which are the objective of this invention. They also provide low surface energy, flat surfaces to which the other constituents of the composition can bond. The metal flakes can be produced by techniques well known in the art by milling the corresponding metal powder with a lubricant, which is frequently a fatty acid or fatty acid soap.

As is known, to achieve and preserve the desired degree of dispersion of metal particles it is essential that one stabilize the particles so that they do not aggregate. Metal particles can be stabilized by coating the particles with a surfactant or stabilizer ligands to prevent metal-to-metal contact. Suitable surfactants and stabilizer ligands include carboxylic acids and metal soaps of carboxylic acids which can be preformed or formed *in situ*.

Particulate metals may also include micron-sized spherical powders, which may include single, bimodal, or trimodal particle size distributions to enhance the packing density. It is preferred to have a narrow size distribution for each modal of the powders to maximize the packing density. For screen printing circuit traces/components, a preferred formulation is comprised of particulate metal in an amount of from 60 to 85% by weight, where the nanopowder is present in an amount of from 20 to 50% by weight of the total particulate metal.

Many classes of organic compounds can function as the ligands X and L in a compound of the formula M^{(+a)}_{y}X^{(-b)}_{w}L_{z} as described above. The common characteristic which they share, and which renders them effective, is that they have, or can form, a bond to the metal via a hetero-atom to give a coordination type compound or they can form a metal bond to carbon thus forming metallo-organic decomposition compounds. The hetero-atoms can be oxygen, nitrogen, sulfur, phosphorous, arsenic, selenium and other nonmetallic elements, preferably oxygen, nitrogen or sulfur. X may be a negatively charged ligand selected from carboxylate, halocarboxylate, amide, haloamide, amido, imino, haloimino, beta-diketone, halo(beta-diketone), beta-ketoimine, halo-(beta-ketoimine), beta-diimine, halo(beta-diimine), beta-ketoester, halo-(beta-ketoester), beta-ketoamide, halo-(beta-ketoamide), alkoxy, haloalkoxy, aminoalkoxy, phenoxy, halophenoxy, alkyl, fluoroalkyl, aryl, haloaryl, alkenyl, haloalkenyl, haloalkyne, trifluoromethylsulfonate, beta-ketoimine olefin, beta-diimineolefin, halide, nitride, hydroxide, sulfate, sulfite, nitrate, nitrite, carbonate, bicarbonate, and mixtures and the ligand L may be a neutral ligand selected from ammonia, and substituted amine, diamine, triamine, imine, nitrile, alkene, alkyne, carbon monoxide or alkyl or phenyl substituted phosphine complexes.

Specific examples of metal precursors of the formula M^{(+a)}_{y}X^{(-b)}_{w}L_{z} include metallic soaps of neodecanoic acid and 2-ethylhexanoic acid. Copper and silver formate, neodecanoate and 2-ethylhexanoate are representative of the carboxylates. Metal amine 2-ethylhexanoates and amine octanoates are examples of using nitrogen derivatives and metal t-dodecyl mercaptides are examples of using a sulfur derivative as the ligand for the metal, e.g., copper. Copper ((4-N-methylimino)-3-pentene-2-onato)trimethylvinyl silane is an example of a compound having both an X and L ligand. Other specific examples include copper acetate, copper trifluoroacetate, copper nitrate, copper methoxide, copper ketoimine, copper thiosulfate, copper pentafluoropropionate, copper octanoate and the corresponding silver derivatives of such copper compounds, e.g., silver trifluoroacetate, silver thiosulfate, and so forth.

It is common to include a solvent or liquid vehicle in the paste or ink formulation. The purpose of the solvent is to dissolve metal precursors, while the purpose of a liquid vehicle is to adjust viscosity. In certain preferred embodiments, a solvent can also act as a vehicle. The solvents and vehicles should have suitable vapor pressures, which should not be too high to maintain their work life during sintering and should not be too low as to prevent removal when their work functions are completed. The solvents and vehicles should not degrade or negatively impact the performance of the substrates, and should have low impurities, low toxicities of vapors, and low tendency of leaving organic residue. In addition, it is preferred that the solvents provide high solubility for metal precursors. Alpha-terpineol is an example of a vehicle for reducing the viscosity of copper and silver compositions to facilitate screen printing. Alpha-terpineol with an OH group and ring monounsaturation also appears to participate in the consolidation of ink formulations. By selecting solvents and vehicle additives, it is possible to produce a range of printable compositions ranging from fluid inks with a viscosity of 10 centipoises (0.01 Pa.s) to pastes with a viscosity of 40,000 to 60,000 centipoises (40 to 60 Pa.s).

It is preferred that the metal precursors, as well as other agents, employed in the ink or paste have a high degree of purity and high solubility in the solvent, if employed. It is also preferred that the metal precursor and other agent also have chemical stability and a low tendency of generating toxic volatiles under ambient condition. They should possess a low tendency of leaving organic residue and generate low toxicity volatiles on cure. In addition, those metal precursor compounds that have a high metal yield and low reduction temperature are preferred.

The metal precursor can be either solid or liquid, and can be either initially added in the conductor formulation or formed *in situ* during heating. The metal precursor can also be precoated on the surface of the particulate metal used in the conductor formulation.

Specific examples of the above described representative inks or pastes for producing electrical conductors include the compositions of the type marketed under the PARMOD™ trademark by Parelec, Inc. of Rocky Hill, New Jersey, USA. Further detail on specific commercially available inks or paste formulations containing conductive metal formulations for use in generating conductive metal films and particularly copper films are described in US 6,036,889, US 6,143,356, US 6,153,348, US 6,274,412 B1, US 6,379,745 and WO 03/032084 (2003/018045), in addition to the extensive description of metal containing inks and conductor precursors given in this text above.

It has been found that electron attachment (EA) can be used to facilitate the formation of electrical conductors comprised of metal carried on a substrate. More specifically, it has been found that EA can allow one to form the electrical conductors by effecting conversion of the conductor formulations to metal at lower temperatures than previously possible.

The principal of electron attachment used in forming electrical conductors on a substrate, particularly paper and polymeric substrates, is the establishment of an electrically activated reducing gas and exposing the metal powder or metal precursor formulation thereto. While it is believed electrical activation of the reducing gas results in a negatively charged ionic reducing gas, there may be positively charged and neutral species present in the electrically activated reducing gas. In one procedure for employing electron attachment, a gas mixture of a carrier gas such as nitrogen and a reducing gas, such as hydrogen, is introduced into a heating chamber, oven or a furnace with a cathode and anode and the substrate connected to the anode to form a target assembly. A pulsed DC voltage is applied between the cathode and the anode to generate low-energy electrons at the cathode. These electrons drift to the anode in the electric field and during this electron drift, a part of the molecular reducing gas, i.e., H₂, forms negative ions by electron attachment. They too, drift to the anode. At the anode, the negatively charged ionic hydrogen interacts with the metal precursor and particulate metal. The interaction, stoichiometrically or catalytically, not only reduces any surface oxides on the metal particles but also helps to break metal bonds to other elements, releasing metal from the metal precursor and this "fresh" or newly generated metal accelerates the fusing or sintering thereof. During this process, the carrier gas is selected to have an electron affinity less than that of the reducing gas, so that it is presumed not to be affected. N₂ is particularly desirable as a carrier gas since its electron affinity is zero, its cost is low, and it has no safety and environmental problems.

Electrical activation of the reducing gas by low energy electrons, as for example from hydrogen molecules, can be accomplished by: photoemission from a photosensitive cathode, electron beam techniques, radioactive source techniques, and avalanche techniques where cascading initial electrons drift to successively higher potential electrodes in an electrode array, releasing additional electrons from each succeeding electrode. Photoemission of free low energy electrons may occur following, for example, exposure of a photosensitive source to ultraviolet or other suitable wavelength light. In those techniques where the electrons are not emitted employing a DC voltage (i.e., photoemission), the cathode and anode should be biased to draw the generated electrons and ultimately the negatively charged ionic ions to the anode.

The reducing gas used in EA generally falls within two categories: 1) the gas is an intrinsically reducing gas, and 2) the gas is capable of generating active reducing species. The first category of gases includes any gas that can act as a reductant to the metal in the conductive metal formulation. Examples of intrinsically reductant gases include H₂, CO, SiH₄, Si₂H₆, formic acid, alcohols such as, for example, methanol, ethanol. The second category of reducing gas includes any gas that is not intrinsically reductive but is capable of generating an active species, such as, for example, H, C, S containing gases forming H⁻, C⁻, and S⁻ respectively, by dissociative attachment of electrons on the gas molecules. Examples of this type of gas include: ammonia, lower alkyl amines, hydrazine, hydrogen sulfide, and C₁ to C₁₀ hydrocarbons.

In addition to mixtures including one or more of the above categories of EA reducing gases, the EA gas mixture may further contain one or more carrier gases. The carrier gas may be used, for example, to dilute the reducing gas, to provide collision stabilization, and to pass electrons to the reducing gas. The carrier gas used in the gas mixture may be any gas with an electron affinity less than that of the reducing gas within the gas mixture. In certain preferred embodiments, the carrier gas is an inert gas. Examples of suitable inert gases include, but are not limited to, N₂, Ar, He, Ne, Kr, and Xe.

In the implementation of the EA process for forming electrical conductors, the concentration of reducing gas in the gas mixture may be between 0.1 to 100% by volume. In preferred embodiments, the gas mixture comprises hydrogen as the reducing gas and nitrogen as the carrier gas and the gas mixture comprises from 1 to 4% by volume of hydrogen. Amounts of hydrogen equal to or lower than 4 vol% are preferred, because the EA gas mixture is non-flammable.

Substrates that may be used in the formation of electrical conductors include the conventional high temperature substrates, e.g., glass or silicon and its oxides but also low temperature substrates such as paper and polymeric substrates. Suitable polymer substrates include polyethylene terephthalate, Kapton™ polyimide, polyethylene naphthalate, polyether sulfone, polyetherimide, polycarbonate, polynorbornene, polyarylate, and polyether ketone. For some applications even lower temperature substrates such as polyethylene, polypropylene, and poly(vinyl chloride) may be preferred.

It seems a key requirement for applying EA for converting various conductor formulations into metal conductors that one needs to drain the electrical charge during sintering while maintaining the dielectric nature in the X-Y plane when sintering is completed. Grounded electrically conductive substrates and porous substrates are examples of ways to achieve the result. In the first approach one can surface coat a dielectric substrate such that the coating layer can be changed from insulating to conductive during heating or at high potentials. Alternatively, a semiconductive coating layer can be applied on the dielectric substrates, or the substrates can be intrinsically semiconductive. In such ways, the electrical functions of the developed conductors can still be maintained. In the second approach one can use substrates such as porous polyethersulfone (PES) and porous paper which can pass the electric current along the Z axis. In a third approach, the printed features may be grounded via a temporary electrical connection to ground or the anode. The pore size of the porous substrates may range from 10 nm to 1 mm, preferably from 100 nm to 10 µm, and more preferably from 100 nm to 1 µm. The temperature range for forming electrical conductors via EA assisted conversion is generally within a range of 25 to 350 °C, preferably 25 to 200 °C, and more preferably 100 to 150 °C. The DC voltage may comprise between -1 to -50 kV, although the preferred range is between -2 to -10 kV. The cathode or other device by which the electrons are generated (photoemissive or radioactive source) should be close to the anode. The distance between the cathode and the top surface of the substrate to be treated may be 0.5 to 10 cm, and the preferred range is 1 to 2 cm. The voltage applied between the two electrodes can be constant or pulsed. A voltage pulse is preferred to be used to minimize arcing. The frequency of the voltage pulse may range from 0 to 100 kHz, preferably 5 to 20 kHz.

To accommodate open and continuous production lines, the EA operating pressure preferably is ambient atmospheric pressure. To increase the efficiency of generating ionic reducing gas by electron attachment, however, it may be preferred to operate the process at super atmospheric pressures, such as up to 60 atmospheres (6 MPa), but generally pressures are from 10 to 50 psia (70 to 350 kPa).

In forming the electrically conductive lines and features using conductor formulations, e.g., inks or pastes comprised of a metal particle or metal precursor or both, the formulations may be applied to the substrate using any convenient technique. Screen printing and stenciling are suitable for rigid and flexible substrates. Gravure printing, impression printing and offset printing are suitable for high production rates on flexible substrates. Ink jet printing and electrostatic printing offer the advantage of direct computer control of the printed image. These methods permit circuits to be printed directly from Computer Aided Design (CAD) files and they eliminate the need for special tooling. Each circuit can be different, if desired, for coding or prototyping. The same end can be achieved at lower production rates with computer-controlled dispensing equipment. This equipment produces dots or lines by moving a needle over the surface and dispensing printing composition supplied by a pump or pressurized syringe. Other methods include, but are not limited to, rotary screen printing, flexographic printing, electrographic printing, laser-trench-and-fill, dip pen nanolithography and thermal transfer from a precoated ribbon.

While not wishing to be bound by theory, an embodiment of the proposed low-temperature metal sintering process, e.g., copper or silver sintering, under EA assisted conditions is illustrated as follows: During sintering, a gas mixture of ≤ 4 vol% H₂ in N₂ is introduced into a furnace. The furnace contains heating and cooling zones located at different sections along the center axis, and a moving belt from one end to another end of the furnace. Inside the furnace an electron-emitting cathode is mounted overhead, and a rigid or flexible substrate with a conductive copper (or other metal or mixture of metals) formulation printed thereon is placed onto a grounded moving belt. When a suitable voltage is applied to the cathode, low energy electrons are generated from the cathode and move toward the printed substrate driven by the electric field. The molecular hydrogen then collides with these electrons, forming neutral and negatively charged atomic hydrogen. The negatively charged atomic hydrogen ions move along the electric field toward the substrate, which leads to a preferential adsorption of active species on the substrate surface. Metal is released from the metal precursor, any oxides on metal particle surfaces are reduced, and this mixture fuses to form a sintered electrical conductor on the substrate. On the substrate surface, free electrons injected from the cathode, or generated as a by-product of the chemical reactions on the substrate, are discharged to the ground along the Z axis of the substrate or through the grounded coating layer of the substrate.

To apply EA for low-temperature copper sintering, it is desired to have a cathode, which can generate low-energy electrons uniformly above the surface of the substrate and have a long lifetime of operation under ambient pressure of a gas environment containing H₂ and N₂. It was found that a cathode composed of a metal plate with distributed emission tips was preferred. To maximize the electric field, each emission tip was made from Ni/Cr wire 0.025 inch (0.6 mm) in diameter and machined to provide a sharp tip of 10 degree angle that protruded 1.5 cm out of the metal plate surface. For a given distance of 1 cm between the emission tips and the treating surface, the tip spacing was optimized to be around 1 cm based on a tradeoff between minimized interference of electric fields among adjacent tips and maximized surface coverage of electron emission.

The following examples are intended to illustrate various embodiments of the invention and are not intended to restrict the scope thereof

### Example 1

### Electrical Conductor From Mixtures of Metal Powders

This example demonstrates the formation of electrical conductors using a copper powder under Electron Attachment in an atmosphere of 4 vol% H₂ in N₂ as the reducing gas.

A batch of copper paste containing α-terpineol and nanometer copper powder in a weight ratio of 1:2 was mixed in a glove box and milled with a lab-scale milling machine. The milled paste was then screen printed onto an aluminum foil (to ground the paste during EA). The foil was grounded by placing on top of a metal anode. A cathode having long pins was set above the foil. The gap between the tips of the emission pins and the foil was around 1 cm. When a voltage around 3.5 KV was applied, electron emission having a current of 0.25 mA/tip was obtained. The printed traces were sintered by heating in 4 vol% H₂ in N₂ to 120 °C and holding for ten minutes. This was done with and without EA during the holding period. The sintered copper traces were then transferred to an electrically insulated tape to measure their electrical resistance. The results showed that the copper pattern formed using EA had a low conductivity and exhibited a bright copper color, demonstrating a typical oxide-free and partially sintered copper film. In contrast, the color of the copper pattern where EA was not applied was dark brown, similar to that of the as-printed pattern, and the conductivity was zero, indicating non-sintering surface oxides on the nano powder surface. The resulting copper patterns without addition of copper compounds to bond the particles together were in both cases fragile.

### Example 2

### Effect of Electron Attachment (EA) in Forming a Copper Conductor from a Copper Ketoimine Compound

To demonstrate the effect of EA in electrical conductor formation the following experiment was conducted. A copper paste containing liquid Cu(II) ketoimine of formula Cu(MeC(O)CHC(NEt)Me)₂, micron sized copper powder, and nanoparticulate copper powder in a weight ratio of 0.128, 0.698, and 0.181 respectively was mixed in a N₂ purged glove box and milled with a three roll milling machine. The milled paste was then screen printed on an aluminum foil substrate. The printed traces were then sintered in 4 vol% H₂ in N₂ to 200°C and held at 200°C for 10 minutes, one while applying EA and the other in the absence of EA during the holding period. The sintered copper traces were then transferred to an electrically insulated tape to measure their electrical resistance.

It was found that the sample sintered by the application of EA had a low conductivity, while the sample without applying EA was completely nonconductive. It was also observed that the color of the sintered pattern on the sample formed by the application of EA was significantly brighter than the one not employing EA, showing the effect of EA in helping to release copper metal from the copper precursor, reducing the surface oxides on Cu powders, and effecting sintering of the copper. Therefore the EA assisted formation of the electrical conductor at 200 °C was significantly better in terms of copper sintering and electrical conductivity than the electrical conductor formed without EA.

### Example 3

### Effect of Electron Attachment (EA) In Conductor Formation From Copper Ketoimine

To quantitatively demonstrate the effect of EA in facilitating reduction of a Cu(II) ketoimine as the sole metal precursor at low temperature in 4 vol% H₂ in N₂, the following experiment was conducted. Two samples were prepared, each containing a few drops of the liquid Cu(II) ketoimine of Example 2 on aluminum foil. Sample 3-1 was heated to 200°C and held ten minutes with EA and Sample 3-2 without EA.

After the heat treatments with EA and without EA, the two samples were analyzed by oxidizing them *in-situ* inside an air purged TGA/DSC (Thermogravimetric Analysis / Differential Scanning Calorimetry) apparatus. In this way any organic residues were air oxidized as they were heated in the TGA apparatus. By measuring the weight loss of the samples resulting from the oxidation of compounds containing carbon, hydrogen and nitrogen to their volatile oxides (CO₂, H₂O, NOₓ etc), estimates of the relative masses of organic residues remaining after the heat treatments were obtained. Similarly, the magnitude of the volatile oxides was also measured by FTIR (Fourier Transform Infrared Spectroscopy).

The results showed that the organic residue for sample 3-1 was much lower than that of sample 3-2, when EA was not applied. Thus, by using EA one is able to lower the temperature required for releasing copper metal from the precursor, and therefore lower the sintering temperature of the copper metal.

### Example 4

### Effect of Electron Attachment (EA) In Copper Conductor Formation From Copper Neodecanoate

To demonstrate the effect of EA in generating an electrical conductor using only a copper precursor compound, the following experiment was conducted. Two samples each containing a few drops of a liquid solution containing 60 wt% copper (II) neodecanoate and 40 wt% toluene and having a fresh blue color were applied to an aluminum foil. The two samples were then heated to 200 °C under 4% H₂/N₂ and held for 10 minutes with and without applying EA.

When EA was applied, the liquid drops after the heating cycle turned into a film with a brown copper color, indicating a conversion from copper neodecanoate into copper. However, when EA was not applied, the liquid solution changed into a solid phase with a very dark color, indicating that the copper neodecanoate was not converted to copper metal.

### Example 5

### Effect of Electron Attachment (EA) In Conductor Formation from Copper Formate

The following experiment was conducted to demonstrate the formation of a copper conductor using copper formate (a copper precursor) under EA in 4 vol% H₂ in N₂. A saturated solution of copper formate in water (12.5g/100cm³) was dropped onto an aluminum foil, heated to 150 °C in 4% H₂ in N₂ and held ten minutes under EA and non EA conditions.

It was found that when EA was applied, a copper color film was formed. A XPS (X-ray Photoelectron Spectroscopy) analysis was conducted for the formed film which confirmed that the film was copper with surface oxides and trace amounts of organic and inorganic residues. Without applying EA at 150 °C, the treated sample had a green/blue color, indicating unconverted copper formate and the failure to reduce the metal precursor and form a copper conductor.

### Example 6

### Conductor Formation From a Mixture of Copper Powders with Organic Surface Functionality

To demonstrate the benefit of EA in improving the electrical performance of a sintered copper film, a batch of copper paste was made by mixing neodecanoic acid, copper micron powder, and copper nano powder in a N₂ purged glove box in a weight ratio of 0.128, 0.698, and 0.181, respectively. After mixing, the formulation was milled in a lab-scale milling machine. The milled paste was then printed onto an aluminum foil (to temporarily avoid any discharging problem when applying EA). Each sample of printed copper precursor formulation on aluminum foil was sintered under a given gas environment and at a peak temperature for ten minutes either using or not using EA. The sintered copper traces were then transferred to an electrically insulated tape to measure their electrical resistance. The results are provided in Table 1.

**Table 1**

| A Comparison of the Electric Performance of Sintered Copper Paste | | | |
|---|---|---|---|
| Gas | EA | Peak Temp. (°C) | Resistivity (µΩ-cm) |
| N₂ | No | 350 | 28.9 |
| N₂ | No | 200 | ∞ |
| 4 vol% H₂/N₂ | No | 200 | 67.8 |
| 4 vol% H₂/N₂ | Yes | 200 | 15.5 |

As indicated in Table 1, when EA was applied using 4 vol% H₂ in N₂, the peak sintering temperature of the conductive copper was reduced from 350 to 200 °C while obtaining an electrical conductor having significantly lower electrical resistivity than when EA was not applied. In addition, it was also found that the mechanical strength of the sintered trace when EA was applied was significantly higher than that when EA was not applied.

It is believed that during sintering the added neodecanoic acid reacts with the surface oxides of the copper powders, yielding a transient copper precursor. When the sintering temperature is relatively high (e.g. 350 °C), the *in situ* formed copper precursor can be thermally decomposed to generate copper and effect sintering of the powder mixture. When EA is applied during sintering in 4 vol% H₂ in N₂, the reduction of the copper precursor by H₂ can be largely promoted at 200 °C.

### Example 7

### Effect of Exposure Time Using Electron Attachment

To investigate the effect of EA exposure time for sintering of copper formulations into electrical conductors, the following experiments were conducted. As in Example 6 a batch of copper paste was made by mixing neodecanoic acid, copper micron powder, and copper nano powder in a N₂ purged glove box with a weight ratio of each ingredient of 0.128, 0.698, and 0.181, respectively. After mixing, the mixture was milled in a lab-scale milling machine. The milled paste was then screen printed on a piece of silicon wafer in order to temporarily avoid any discharging problem during the application of EA and to allow a direct measurement of electrical resistance of the sintered conductor.

Two samples of the printed copper paste on silicon were sintered in a reducing gas containing 4 vol% H₂ in N₂. For sintering of the first sample, EA was applied during heating from 150 to 200 °C at which time EA was discontinued. For sintering of the second sample, EA was applied during heating from 150 to 200 °C and while holding at 200°C for two minutes.

The electrical resistivities of the two samples were found to be the same, indicating that the EA assisted chemical reductions could be achieved during heating and that the holding time at 200 °C for additional EA exposure was unnecessary.

### Comparative Example 8

### Dissipating Electrical Charge Using a Porous Paper Substrate

The purpose of this example was to determine if porous paper could be used as a substrate when EA was applied to facilitate the sintering of copper formulations.

A porous paper especially used as a flexible substrate with excellent paste printability was purchased from Stora Enso. This paper can sustain 200 °C in air without oxidation damage. The paper was put on the top of a metal anode. A cathode having long pins was set above the paper. The gap between the tips of the emission pins and the paper was around 1 cm. When a voltage around 3.5 KV was applied, electron emission having a current of 0.25 mA/tip was obtained. EA at 200 °C using 4 vol% H₂ in N₂ for 5 minutes was applied. After the EA exposure, there was no visible color change found on the paper indicating no thermal damage by overheating or by excessive current flow during electron discharge.

The result also shows that the porous paper was capable of allowing an electrical charge to dissipate from the paper through the Z axis, thus enabling EA with an electrically non-conductive substrate

### Example 9

### Sintering of a Copper Powder Conductor Formulation on Porous Paper

This example demonstrates the benefit of using Electron Attachment (EA) assisted 4 vol% H₂ in N₂ for forming an electrical conductor from copper powders on paper.

A batch of copper paste containing α-terpineol and nanometer copper powder in a weight ratio of 1:2 was mixed in a glove box and milled with a lab-scale milling machine. The milled paste was then screen printed onto a surface coated porous paper (made by Stora Enso). The printed traces were sintered by heating in 4 vol% H₂ in N₂ to 120 °C and holding for 5 minutes. In one of the two sintering cases, EA was applied during heating from 100 to 120 °C and for 5 minutes holding time. In another sintering case, EA was not applied.

The results showed that the conductor pattern formed without using EA had a dark brown color similar to that of as-printed pattern, demonstrating a non-sintered film. In contrast, the color of the copper pattern formed when EA was applied had a brighter copper color, indicating oxide removal on powder surface and a partial sintering of the film. Because the conductor formulation did not contain a copper precursor and thus there was no generation of fresh copper to fuse the copper powders during sintering, the conductivity of the sintered films under EA was poor.

### Example 10

### Sintering of Conductor Formulation Made of Copper Powder and Copper Precursor on Porous Paper

This example demonstrates the benefit of using Electron Attachment (EA) assisted 4 vol% H₂ in N₂ for sintering of a conductor formulation made of copper powder and a copper precursor on paper.

A batch of copper paste containing α-terpineol, micron copper powder, and copper formate in the following weight percentages: 11 wt%, 71 wt%, and 18 wt%, was mixed in a glove box and miiied with a lab-scale milling machine. The milled paste was then screen printed onto a surface coated porous paper (made by Stora Enso). The printed traces were sintered by heating in 4 vol% H₂ in N₂ to 150 °C and holding for 5 minutes. In one of the two sintering cases, EA was applied during heating from 100 to 150 °C and the 5 minutes holding time. In another sintering case, EA was not applied.

The results showed that the conductor pattern formed without using EA had a dark brown color similar to that of as-printed pattern, demonstrating a non-sintered film. In contrast, the color of the copper pattern when EA was applied had a significantly brighter copper color, indicating a formation of a sintered film. By measuring the resistance and the thickness of the sintered film, the resistivity of the sintered film was found to be around 232 µΩ-cm. Although the resistivity level is relatively high, this experiment demonstrates that a conductive pattern can be formed on a porous paper at 150 °C under EA assisted 4 vol% H₂ in N₂.

### Example 11

### Sintering of Conductor Formulation Made of Copper Flake and Copper Precursor on Porous Paper

This example demonstrates the benefit of using Electron Attachment (EA) assisted 4 vol% H₂ in N₂ for sintering of a conductor formulation made of copper flake and a copper precursor on paper.

A batch of copper paste containing α-terpineol, copper flake, and copper formate in the following weight percentages: 11 wt%, 71 wt%, and 18 wt%, was made. To have better mixing, the copper formate was mixed and milled with α-terpinol first, then copper flake was added to the mixture and mixed/milled again. The paste was then screen printed onto a surface coated porous paper (made by Stora Enso). The printed traces were sintered by heating in 4 vol% H₂ in N₂ to 150 °C and holding for 5 minutes. In one of the two sintering cases, EA was applied during heating from 100 to 150 °C and the 5 minutes holding time. In another sintering case, EA was not applied.

The results showed that the conductor pattern formed without using EA had a dark brown color similar to that of as-printed pattern, demonstrating a non-sintered film. In contrast, the color of the copper pattern when EA was applied had a significantly brighter copper color, indicating formation of a reduced and sintered film. By measuring the resistance and the thickness of the sintered film, the resistivity of the sintered film was found to be around 97 µΩ-cm, significantly better than the case of using micron copper powder in the paste (Example 10). This experiment further demonstrates that a conductive pattern can be formed on porous paper at 150°C under EA assisted 4 vol% H₂ in N₂, and the conductivity can be improved when copper flake is used instead of micron copper powders.

### Example 12

### Sintering of a Conductor Formulation Made of Copper Powder and a Crystalline Copper Precursor on Silicon Wafer

This example demonstrates the benefit of using Electron Attachment (EA) assisted 4 vol% H₂ in N₂ for sintering of a conductor formulation made of copper powder and a crystalline copper precursor on silicon wafer. (The copper precursor is in finely divided solid form.)

A batch of copper paste containing α-terpineol, micron copper powder, and copper formate in the following weight percentages: 11 wt%, 71 wt%, and 18 wt%, was mixed in a glove box and milled with a lab-scale milling machine. The milled paste was then screen printed onto a silicon wafer. The printed traces were sintered by heating in 4 vol% H₂ in N₂ to 150 °C and holding for 5 minutes. In one of the two sintering cases, EA was applied during heating from 100 to 150 °C and the 5 minutes holding time. In another sintering case, EA was not applied.

The results showed that the conductor pattern formed without using EA had a dark brown color similar to that of as printed pattern, demonstrating a non-sintered film. In contrast, the color of the copper pattern when EA was applied had a significantly brighter copper color, indicating a formation of a sintered film. By measuring the resistance and the thickness of the sintered film, the resistivity of the sintered film was found to be around 29 µΩ-cm. This experiment demonstrates that a conductive pattern can be formed on a semiconductive substrate at 150 °C under EA assisted 4 vol% H₂ in N₂.

### Example 13

### Sintering of Conductor Formulation Made of Copper Powder and Dissolved Copper Precursor on Silicon Wafer

This example, in contrast to Example 12, demonstrates the benefit of using Electron Attachment (EA) assisted 4 vol% H₂ in N₂ for sintering of a conductor formulation made of copper powder and a dissolved copper precursor on a silicon wafer.

A solution containing ammonium hydroxide (30 wt% in water) and copper formate with a weight ratio of one to one was made, where the copper formate powders were completely dissolved. A copper paste containing 12 wt% of the solution and 88 wt of micron powders was mixed in a glove box and milled with a lab-scale milling machine. The milled paste was then screen printed onto a silicon wafer. The printed pastes were sintered by heating in 4 vol% H₂ in N₂ to 150°C and holding for 5 minutes. In one of the two sintering cases, EA was applied during heating from 100 to 150 °C and the 5 minutes holding time. In another sintering case, EA was not applied.

The result showed that the conductor pattern formed without applying EA had a dark brown color and an infinite electrical resistivity. In contrast the color of the copper pattern when EA was applied had a significantly brighter copper color indicating a formation of a sintered film. The resistivity of the sintered film was found to be 7 µΩ-cm. This experiment further demonstrates that a conductive pattern can be formed at 150°C under EA assisted 4 vol% H₂ in N₂.

### Example 14

### Effect of Electron Attachment (EA) In Silver Conductor Formation From Silver Neodecanoate

Silver neodecanoate powder was put on an aluminum foil and heated to 150 °C in a reducing gas of 4% H₂ in N₂ and held for 10 minutes under EA and non EA conditions.

It was found that when EA was applied, a silver color film was formed. In the sample where EA was not employed, the sample had a gray/blue color. It appeared the silver neodecanoate had melted during heating and resolidified on cooling without conversion to silver.

### Example 15

### Effect of Electron Attachment (EA) In Silver Conductor Formation From a Commercially Available Silver Paste

A commercially available silver paste was bought from Parelec, Inc. and printed on Kapton™ polyimide film. The recommended temperature for sintering of this silver paste is 150°C in air or N₂ for 5 to 10 minutes. The printed traces were sintered by heating in 4 vol% H₂ in N₂ to 120 °C and holding for 5 minutes. In one of the two sintering cases, EA was applied during heating from 100 to 150 °C and the 5 minutes holding time. In another sintering case, EA was not applied.

The results showed that the pattern formed without using EA was not conductive. In contrast, the pattern when EA was applied had a resistivity of 18 (µΩ-cm). This experiment demonstrates that a silver conductive pattern can be formed on Kapton™ at a temperature as low as 120 °C under EA assisted 4 vol% H₂ in N₂.

### Example 16

### Sintering of ITO Film Made of ITO Powder and Copper Precursor on Silicon Wafer

This example demonstrates the benefit of using Electron Attachment (EA) assisted 4 vol% H₂ in N₂ for sintering of an indium/tin oxide (ITO) film made of ITO powder and a metal precursor on silicon wafer.

A batch of ITO paste formulation containing α-terpineol, ITO powder, and copper formate in the following weight percentages: 11 wt%, 71 wt%, and 18 wt%, was mixed in a glove box and milled with a lab-scale milling machine. The milled paste was then screen printed onto a silicon wafer. The printed traces were sintered by heating in 4 vol% H₂ in N₂ to 150 °C and holding for 5 minutes. In one of the two sintering cases, EA was applied during heating from 100 to 150 °C and the 5 minutes holding time. In another sintering case, EA was not applied.

The results show that the pattern formed without using EA was not sintered effectively. In contrast, when EA was applied, a sintered film was formed. This experiment demonstrates that a sintered ITO film can be formed on a semiconductive substrate at 150 °C under EA assisted 4 vol% H₂ in N₂.

In summary, the examples show that electrical conductors can be provided on a variety of substrates, including temperature sensitive substrates, e.g., paper at low temperatures, when using electron attachment to reduce surface oxides of metal powders and convert a metal precursor to metal thus permitting sintering to occur. The examples further show that such conductive films can be formed from commercial powders and metal precursors often used in the formation of electrical conductors at much lower temperatures than employed heretofore without increasing the process time.

## Claims

1. A method of forming an electrical conductor on a substrate which comprises the steps:
applying a conductor formulation, comprised of at least one ingredient selected from metal particles, metal precursors and mixtures thereof, onto a substrate;
exposing the conductor formulation to an electrically activated reducing gas, and converting the ingredient to metal and forming the electrical conductor.

2. The method of Claim 1 wherein the step of exposing the conductor formulation to an electrically activated reducing gas comprises:
positioning the conductor formulation between a first electrode and a second electrode; and
establishing a direct current (DC) voltage between said first and second electrodes to form the electrically activated reducing gas.

3. The method of Claim 1 or 2 wherein said electrically activated reducing gas is a negatively charged ionic reducing gas.

4. The method of any preceding claim wherein said reducing gas is selected from hydrogen, ammonia, carbon monoxide and mixtures thereof.

5. The method of Claim 4 wherein said reducing gas is hydrogen which is present in a gas mixture comprising 0.1 to 100% by volume of hydrogen and a carrier gas.

6. The method of Claim 5 wherein said gas mixture is 1 to 4% by volume of hydrogen and a carrier gas.

7. The method of Claim 5 or 6 wherein said carrier gas is selected from nitrogen, helium, argon, neon, krypton, xenon, and mixtures thereof.

8. The method of any preceding claim wherein said conductor formulation is comprised of said ingredient and indium/tin oxide.

9. The method of any preceding claim wherein the conductor formulation is comprised of at least one ingredient selected from: metal particles; a metal precursor having the formula M^{(+a)}_{y}X^{(-b)}_{w}L_{z} where M is a metal suited for use in producing electrical conductors, X is a negatively charged ligand, and L is a neutral ligand and where ay = bw and a is from 1-5, b is from 1-3 and z is from 0 to 5; and a mixture of said particles and metal precursors.

10. The method of Claim 9 wherein the conductor formulation is comprised of a mixture of (a) a metal precursor of the formula M^{(+a)}_{y}X^{(-b)}_{w}L_{z}; (b) a first metal powder having a particle size of from 1 to 10 microns, (c) a second metal powder comprised of a particle size from 5 to 80 nanometers; and, (d) an organic liquid.

11. The method of Claim 9 or 10 wherein the ligand X is selected from carboxylate, halocarboxylate, amide, haloamide, amido, imino, haloimino, beta-diketone, halo(beta-diketone), beta-ketoimine, halo-(beta-ketoimine), beta-diimine, halo(beta-diimine), beta-ketoester, halo-(beta-ketoester), beta-ketoamide, halo-(beta-ketoamide), alkoxy, haloalkoxy, aminoalkoxy, phenoxy, halophenoxy, alkyl, fluoroalkyl, aryl, haloaryl, alkenyl, haloalkenyl, haloalkyne, trifluoromethylsulfonate, beta-ketonate-olefin, beta-ketoimine olefin, beta-diimineolefin, halide, nitride, hydroxide, sulfate, sulfite, nitrate, nitrite, carbonate, bicarbonate, and mixtures thereof and the ligand L is selected from ammonia, substituted amine, diamine, triamine, imine, nitrile, alkene, alkyne, carbon monoxide or alkyl or phenyl substituted phosphine complexes and mixtures thereof.

12. The method of Claim 11 wherein the ligand X is selected from carboxylate, beta-diketone, beta-ketoimine, beta-diimine, beta-ketoester and mixtures thereof, and z is 0.

13. The method of any preceding claim wherein the metal employed in the ingredient is selected from copper, silver, gold, zinc, cadmium, palladium, iridium, ruthenium, osmium, rhodium, platinum, iron, cobalt, nickel, manganese, indium, tin, antimony, lead, bismuth, vanadium, chromium, titanium, tantalum, aluminum, magnesium, calcium, strontium, barium, cadmium, gallium, bismuth, and mixtures thereof.

14. The method of Claim 13 wherein the metal employed in the ingredient is selected from palladium, rhodium, platinum, cobalt, nickel, manganese, indium, tin, antimony, lead, bismuth, aluminum and mixtures thereof.

15. The method of Claim 13 wherein the metal employed in the ingredient is selected from copper, silver, platinum, gold and mixtures thereof.

16. The method of Claim 15 wherein said metal employed in the ingredient is selected from copper, silver and mixtures thereof.

17. The method of Claim 9 or 10 wherein the conductor formulation is comprised of at least one metal precursor selected from copper formate, copper acetate, copper trifluoroacetate, copper nitrate, copper methoxide, copper neodecanoate, copper ketoimine, copper 2-ethylhexanoate, copper thiosulfate, copper pentafluoropropionate, copper octanoate, the corresponding silver derivatives of such copper compounds and mixtures thereof.

18. The method of Claim 17 wherein the metal precursor is selected from copper formate, copper neodecanoate, silver neodecanoate and mixtures thereof.

19. The method of any preceding claim wherein the substrate is selected from: porous paper; porous polymers selected from polyethylene terephthalate, polyimide, polyethylene naphthenate, polysulfone, and polyetherimide; and mixtures thereof.

20. The method of any preceding claim wherein the substrate is surface coated with a semiconductive material.

21. The method of any preceding claim wherein the temperature employed during said exposure to said electrically activated reducing gas is from 25 to 350 °C.

22. The method of Claim 21 wherein the temperature employed is from 25 to 200 °C.

23. The method of Claim 22 wherein the temperature employed is from 100 to 150 °C.

24. The method of Claim 23 wherein the pressure employed during exposure to said electrically activated reducing gas is from 70 to 350 kPa (10 to 50 psia).

25. The method of any preceding claim, wherein forming the electric conductor comprises sintering the formed metal.

26. A process for forming a film from a conductor formulation comprised of at least one ingredient selected from metal particles, metal precursors and mixtures thereof and converting the ingredient to sintered metal, which comprises exposing the conductor formulation to a negatively charged ionic reducing gas to convert said ingredient to a metal and to sinter the thus formed metal.

27. The process of Claim 25, wherein the conductor formulation, the reducing gas, and/or the temperature and/or pressure employed during exposure to the reducing gas, are as defined in any of claims 4 to 18 and 21 to 24.
